# EUROPÄISCHE PATENTANMELDUNG

(11) **EP 1 139 425 A2**
(43) Veröffentlichungstag der Anmeldung: **04.10.2001**
(21) Anmeldenummer: 01105818.7
(22) Anmeldetag: 08.03.2001
(51) Int. Cl.: H01L 27/108, H01L 21/8242

(54) **DRAM-Speicherzellenfeld mit n- und p-Kanal-Transistoren**

(30) Priorität: 28.03.2000 DE 10015278
(71) Anmelder: Infineon Technologies AG, 81669 München (DE)
(72) Erfinder: Hofmann, Franz, Dr., 80995 München (DE)
(74) Vertreter: Epping Hermann & Fischer

(57) **Zusammenfassung**

Ein Halbleiterspeicher wie beispielsweise ein DRAM (Dynamic Random Access Memory) umfaßt ein Speicherzellenfeld (13) und einer Ansteuerungsperipherie, wobei in dem Speicherzellenfeld (13) eine erste Speicherzelle (14) mit einem ersten Auswahltransistor (16) und einem ersten Speicherkondensator (18) und eine zweite Speicherzelle (15) mit einem zweiten Auswahltransistor (17) und einem zweiten Speicherkondensator (19) angeordnet sind. Der erste Auswahltransistor (16) ist als n-Kanal-Transistor und der zweite Auswahltransistor (17) als p-Kanal-Transistor ausgebildet. Dadurch kann ein Folded-Bitline-Konzept für Speicherzellen realisiert werden, die kleiner als 8*F*² sind.

## Beschreibung

Die vorliegende Erfindung betrifft einen Halbleiterspeicher, der Speicherzellen mit Kondensatoren und Transistoren aufweist.

Speicher werden zur Informationsspeicherung in Datenverarbeitungsanlagen verwendet. Dabei werden zum Beispiel DRAM (Dynamic Random Access Memory) Speicher verwendet, die üblicherweise aus einem Speicherzellenfeld und einer Ansteuerungsperipherie mit Logikschaltelementen bestehen. In dem Speicherzellenfeld sind Speicherzellen angeordnet, die einen Speicherkondensator und einen Auswahltransistor umfassen. Dabei ist das Gate des Auswahltransistors an einer Wortleitung, das Source-Dotiergebiet an den Speicherkondensator und das Drain-Dotiergebiet an einer Bitleitung angeschlossen. Durch Anlegen geeigneter Steuerspannungen an das Gate wird der Auswahltransistor so gesteuert, daß ein Stromfluß zwischen dem Source- und dem Drain-Gebiet durch den Kanal des Auswahltransistors ein- und ausgeschaltet wird.

Neben der Bitleitung sind üblicherweise weitere Bitleitungen angeordnet. Das Schaltungskonzept "Folded Bit Line" verwendet zwei benachbarte Bitleitungen, die mit zwei Eingängen eines Leseverstärkers verbunden sind. Bei dem Leseverstärker handelt es sich dabei meist um zwei verschaltete Inverter, die die beiden benachbarten Bitleitungen miteinander vergleichen und bewerten. Die Wortleitung verläuft quer zu den beiden Bitleitungen und ein Auswahltransistor öffnet sich beim Anlegen einer geeigneten Steuerspannung an die Wortleitung wodurch die in dem Speicherkondensator gespeicherte Ladung auf die erste Bitleitung fließt. An dem Kreuzungspunkt der Wortleitung mit der zweiten Bitleitung ist kein Auswahltransistor angeordnet und die Wortleitung wird hier als Passing-Wordline bezeichnet. Die zweite Bitleitung dient lediglich als Referenz für die erste Bitleitung, auf die die Ladung des Speicherkondensators fließt. Für eine benachbarte Wortleitung tauschen die beiden Bitleitungen ihre Rolle, wobei in diesem Fall die erste Bitleitung als Bewertungsreferenz für die Speicherzelle dient, die an der zweiten Bitleitung angeschlossen ist. Dieses Bewertungsprinzip ist sehr verbreitet, wird wegen seiner Robustheit verwendet und ist in den Patentschriften US 4,443,868 und US 4,807,195 beschrieben. Eine DRAM-Speicherzelle ist beispielsweise in US 5,867,420 angegeben.

Aufgrund der geometrischen Anordnung von Wortleitung und Bitleitung, die beide mit dem kleinsten Strukturmaß F dimensioniert sind, ist die Größe einer Speicherzelle immer größer oder gleich 8F².

Es ist die Aufgabe der Erfindung einen Speicher mit einem Speicherzellenfeld und Speicherzellen anzugeben, der eine Speicherzellengröße von weniger als 8F² ermöglicht.

Erfindungsgemäß wird die Aufgabe gelöst durch einen Halbleiterspeicher mit einem Speicherzellenfeld, in dem
- eine erste Speicherzelle mit einem ersten Auswahltransistor und einem ersten Speicherkondensator und
- eine zweite Speicherzelle mit einem zweiten Auswahltransistor und einem zweiten Speicherkondensator angeordnet sind,
- wobei der erste Auswahltransistor ein n-Kanal-Transistor und der zweite Auswahltransistor ein p-Kanal-Transistor ist und
- wobei die Speicherzellen in einem SOI-Substrat, das eine Isolationsschicht aufweist, gebildet sind.

Die angegebene Anordnung verwendet sowohl n- als auch p-Kanal-Transistoren in dem Speicherzellenfeld. Dabei ist zum Beispiel vorgesehen, daß eine Bitleitung mit n-Kanal-Transistoren und die benachbarte Bitleitung mit p-Kanal-Transistoren verbunden wird. Die n-Kanal-Transistoren haben die Eigenschaft, für niedrige Spannungen am Gate zu sperren und für hohe Spannungen leitend zu werden. Dies bedeutet, daß die Bitleitung mit den n-Kanal-Transistoren aktiv ist, wenn eine hohe Spannung an die Wortleitung angelegt ist. Im Gegensatz dazu zeigt die Bitleitung mit den p-Kanal-Transistoren ein entgegengesetztes Verhalten. Hier sperren die p-Kanal-Transistoren für eine hohe Gate-Spannung und leiten für eine niedrige Gate-Spannung. Wird ein Leseverstärker an die Bitleitung mit den n-Kanal-Transistoren und an die Bitleitung mit den p-Kanal-Transistoren angeschlossen und eine hohe Wortleitungsspannung angelegt, so öffnet der n-Kanal-Transistor, und der p-Kanal-Transistor sperrt, so daß die auszulesende Speicherzelle mit dem n-Kanal-Transistor ausgelesen und die Bitleitung mit den p-Kanal-Transistoren als Referenz verwendet werden kann.

Eine Ausgestaltung der Erfindung sieht vor, daß mindestens einer der Speicherkondensatoren ein Grabenkondensator ist. Die Ausbildung eines Speicherkondensators als Grabenkondensator hat den Vorteil, daß der Speicherkondensator platzsparend mit einer großen Kapazität ausgebildet werden kann. Weiterhin sind die üblicherweise zur Ausbildung von Grabenkondensatoren bekannten Verfahren verwendbar.

Eine weitere Ausgestaltung der Erfindung sieht vor, daß mindestens einer der Speicherkondensatoren ein Stapelkondensator ist. Stapelkondensatoren, auch stacked Kondensatoren genannt, stellen eine weitere Möglichkeit dar, den Speicherkondensator mit einer großen Kapazität in einer platzsparenden Anordnung herzustellen.

Es ist vorgesehen, daß eine Grabenisolation und die Isolationsschicht den ersten Auswahltransistor von dem zweiten Auswahltransistor isolieren. Hierdurch ist die kompakte Anordnung von p-Kanal-Transistoren und n-Kanal-Transistoren ermöglicht.

Es ist auch vorgesehen, daß der erste Auswahltransistor oder der zweite Auswahltransistor als vertikaler Transistor gebildet sind. Hierdurch ist eine weitere kompakte Bauweise für die Speicherzellen und das Speicherzellenfeld ermöglicht, die eine Speicherzellengröße von nur 4 F² ermöglicht.

Es ist weiterhin vorgesehen, daß eine erste Bitleitung mit der ersten Speicherzelle und eine zweite Bitleitung mit der zweiten Speicherzelle verbunden ist und die erste Bitleitung und die zweite Bitleitung mit einem Leseverstärker verbunden sind. Das Anschließen eines Leseverstärkers an die erste Bitleitung, die an n-Kanal-Transistoren angeschlossen ist, und an die zweite Bitleitung, die an p-Kanal-Transistoren angeschlossen ist, ermöglicht in vorteilhafter Weise das Konzept "Folded Bit Line" für Speicherzellengrößen unter 8F².

Weiterhin ist vorgesehen, daß der erste Auswahltransistor ein Gate aus einem Mid-Gap-Material aufweist, welches so gewählt ist, daß die Einsatzspannung des ersten Auswahltransistors die negative Einsatzspannung des zweiten Auswahltransistors ist. Hierdurch ist eine symmetrische Einsatzspannung um den Spannungsnullpunkt für den n-Kanal-Transistor und den p-Kanal-Transistor ermöglicht.

Eine vorteilhafte Ausgestaltung der Erfindung sieht vor, daß für eine erste Wortleitungsspannung der erste Auswahltransistor und der zweite Auswahltransistor sperren. Der Vorteil liegt dabei darin, daß sowohl der erste Speicherkondensator als auch der zweite Speicherkondensator die in ihren gespeicherte Ladung beibehalten, da beide Transistoren sperren.

Weiterhin ist vorgesehen, daß sich der erste Auswahltransistor für eine zweite Wortleitungsspannung öffnet, die größer als die erste Wortleitungsspannung ist. Durch dieses Vorgehen ist es möglich, den ersten Auswahltransistor zu öffnen, um die in der ersten Speicherzelle gespeicherte Information auszulesen.

Weiterhin ist vorgesehen, daß sich der zweite Auswahltransistor für eine dritte Wortleitungsspannung öffnet, die kleiner als die erste Wortleitungsspannung ist. Durch die dritte Wortleitungsspannung ist es möglich, die in der zweiten Speicherzelle gespeicherte Information auszulesen.

Weiterhin hat sich als vorteilhaft erwiesen, daß als Gate-Material für den ersten Auswahltransistor und/oder für den zweiten Auswahltransistor ein mit Dotierstoff dotiertes Polysilizium verwendet wird. Durch die Dotierung des Polysiliziums läßt sich die Einsatzspannung des ersten Auswahltransistors und des zweiten Auswahltransistors einstellen. Dadurch kann zum Beispiel erreicht werden, daß sowohl der erste Auswahltransistor als auch der zweite Auswahltransistor für die erste Wortleitungsspannung sperren.

Weiterhin ist vorgesehen, daß als Dotierstoff Germanium verwendet wird. Mit der Verwendung von Germanium als Dotierstoff lassen sich die Einsatzspannungen von p- und n-Kanal-Transistoren symmetrisch zu null einstellen. Dies ist zum Beispiel vorteilhaft, wenn eine symmetrische Betriebsspannung verwendet werden soll.

In einer weiteren Ausgestaltung der Erfindung ist vorgesehen, daß das Gate-Material für den ersten Auswahltransistor und/oder den zweiten Auswahltransistor Titannitrid, Wolfram und/oder Tantal enthält. Diese Materialien erlauben ebenfalls die Einstellung der Einsatzspannungen von p- und n-Kanal-Transistoren symmetrisch zu null.

Eine Weiterbildung der Erfindung sieht vor, daß zur Verbindung des ersten Speicherkondensators mit einem ersten Source-Dotiergebiet des ersten Auswahltransistors und/oder zur Verbindung des zweiten Speicherkondensators mit einem zweiten Source-Dotiergebiet des zweiten Auswahltransistors ein Silizid verwendet wird. Da das eine Source-Dotiergebiet p-dotiert und das andere Source-Dotiergebiet n-dotiert ist, kann ein Silizid zum Anschließen beider Dotiergebiete verwendet werden, ohne einen pn-Übergang zu bilden, der für eine Spannungskonstellation eine Sperrwirkung aufweisen würde.

In einer weiteren Anordnung ist vorgesehen, die erste Speicherzelle auf einem SOI-Substrat zu bilden. Ein SOI-Substrat ermöglicht in vorteilhafter Weise die Anordnung von p-Kanal-Transistoren und n-Kanal-Transistoren in unmittelbare Nähe. Ohne SOI-Substrat werden die p-Kanal-Transistoren und n-Kanal-Transistoren üblicher Weise durch in Sperrrichtung vorgespannte pn-Übergänge voneinander isoliert. Da dies sehr platzaufwendig ist, bedeutet die Verwendung eines SOI-Substrats, bei dem eine isolierende Siliziumoxidschicht zur Isolation von n-Kanal-Transistoren und p-Kanal-Transistoren verwendet werden kann eine enorme Platzersparnis.

Weiterhin ist vorgesehen, daß die erste Speicherzelle und die zweite Speicherzelle mit einer Grabenisolation voneinander isoliert sind. Die Verwendung einer Grabenisolation, auch STI (Shallow Trench Isolation) genannt, ermöglicht eine weitere Platzersparnis, da benachbarte Transistoren und Dotiergebiete voneinander isoliert werden können.

In einer weiteren Ausgestaltung der Erfindung ist zwischen der Grabenisolation und einer Isolationsschicht des SOI-Substrats eine leitfähige Schicht angeordnet. Üblicher Weise ist das Kanalgebiet von Transistoren, die auf einem SOI-Substrat gebildet sind, nicht angeschlossen, da der Bulk-Kontakt durch die Isolationsschicht des SOI-Substrats verhindert wird. Durch das Vorsehen einer leitfähigen Schicht zwischen der Isolationsschicht des SOI-Substrats und einer Grabenisolation ist es zum Beispiel möglich, das Kanalgebiet über die leitfähige Schicht zu kontaktieren, so daß die von SOI-Transistoren bekannten Nachteile, wie Ladungsakkumulation im Kanalgebiet, vermieden wird.

Weitere Ausgestaltungen der Erfindung sind in den Unteransprüchen angegeben.

Die Erfindung wird nachfolgend anhand von Ausführungsbeispielen unter Zuhilfenahme von Figuren weiter erläutert.

In den Figuren zeigen:
- Figur 1: die Draufsicht auf eine Anordnung von Speicherzellen bestehend aus Auswahltransistoren und Speicherkondensatoren, wobei p- und n-Kanal-Transistoren ausgebildet sind;
- Figur 2: ein Schnittbild entlang der Schnittlinie BBn aus Figur 1 für Stacked-Kondensatoren;
- Figur 3: ein Schnittbild entlang der Schnittlinie BBp aus Figur 1 für Stacked-Kondensatoren;
- Figur 4: ein Schnittbild entlang der Schnittlinie BBn aus Figur 1, wobei das STI (Shallow Trench Isolation) nicht bis zu der Isolationsschicht des SOI-Substrats (Silicon on Insulator) gebildet wurde;
- Figur 5: ein Schnittbild entlang der Schnittlinie BBp aus Figur 1, ebenfalls mit angehobenem STI;
- Figur 6: ein Schnittbild entlang der Schnittebene AA aus Figur 1;
- Figur 7: ein Schnittbild entlang der Schnittlinie BBn aus Figur 1 mit Grabenkondensatoren;
- Figur 8: ein Schnittbild entlang der Schnittlinie BBp aus Figur 1 mit Grabenkondensatoren;
- Figur 9: ein Schnittbild entlang der Schnittlinie BBn aus Figur 1 mit Grabenkondensatoren und angehobenem STI;
- Figur 10: ein Schnittbild entlang der Schnittlinie BBp aus Figur 1 mit Grabenkondensatoren und angehobenem STI;
- Figur 11: ein Schnittbild entlang der Schnittlinie AA aus Figur 1 mit Grabenkondensatoren;
- Figur 12: die Draufsicht auf eine Anordnung von Speicherzellen bestehend aus Auswahltransistoren und Speicherkondensatoren, wobei die Auswahltransistoren als n-Kanal-Transistoren und p-Kanal-Transistoren ausgebildet sind;
- Figur 13: die Draufsicht auf einen aus Figur 12 herausvergrößerten Bereich, bei dem der Verlauf der Wortleitungen herausvergrößert ist;
- Figur 14: ein Schnittbild entlang der Schnittlinie DDn aus Figur 12 mit Grabenkondensatoren;
- Figur 15: ein Schnittbild entlang der Schnittlinie DDp aus Figur 12 mit Grabenkondensatoren;
- Figur 16: Ein Schnittbild entlang der Schnittlinie CC aus Figur 12.

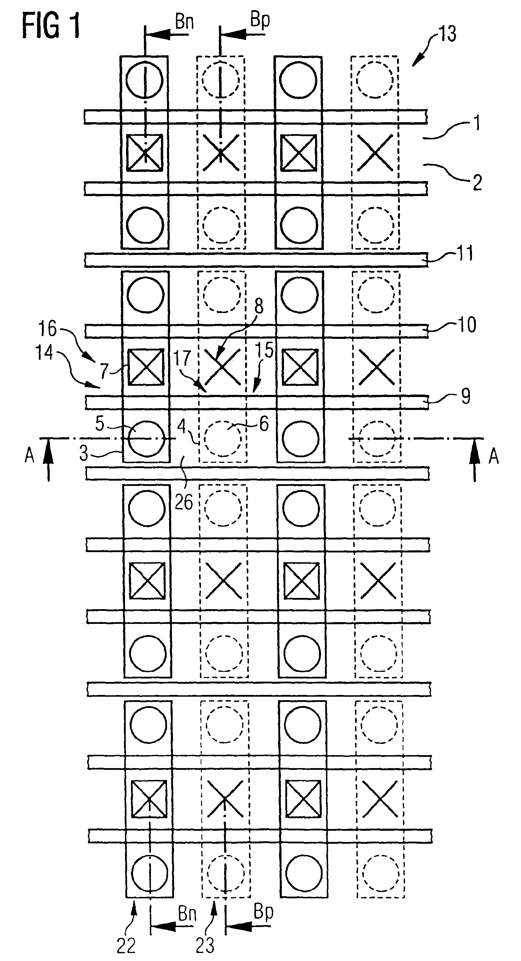

In Figur 1 ist die Draufsicht auf ein Speicherzellenfeld 13 dargestellt. Das Speicherzellenfeld 13 ist auf einem Substrat 1 gebildet. Dabei handelt es sich beispielsweise um ein SOI-Substrat (Silicon on Insulator), das eine vergrabene Isolationsschicht 12 aufweist. In dem Substrat 1 ist ein aktives n-Kanalgebiet 3 und ein aktives p-Kanalgebiet 4 gebildet. Das aktive n-Kanalgebiet 3 ist zum Beispiel schwach p-dotiert, das aktive p-Kanalgebiet ist schwach n-dotiert. Über das aktive n-Kanalgebiet 3 und das aktive p-Kanalgebiet 4 verlaufen eine erste Wortleitung 9 und eine zweite Wortleitung 10. Das aktive n-Kanalgebiet 3 und das aktive p-Kanalgebiet 4 sind durch eine Grabenisolation 26 voneinander isoliert. In dem aktiven n-Kanalgebiet ist eine erste Speicherzelle 14 bestehend aus einem ersten Auswahltransistor 16 und einem ersten Speicherkondensator 18 gebildet. Weiterhin ist ein erster Bitleitungskontakt 7 und ein n-Kanal-Kondensatoranschluß 5 in dem aktiven n-Kanalgebiet 3 dargestellt. In dem aktiven p-Kanalgebiet 4 ist eine zweite Speicherzelle 15 mit einem zweiten Auswahltransistor 17 und einem zweiten Speicherkondensator 19 angeordnet. Ebenfalls ist ein zweiter Bitleitungsanschluß 8 und ein p-Kanal-Kondensatoranschluß 6 dargestellt. Die Bitleitungen 22, 23 verlaufen quer zu den Wortleitungen 9, 10, 11 und die erste Bitleitung 22 verläuft über benachbarte aktive n-Kanalgebiete 3 und die zweite Bitleitung 23 verläuft über benachbarte aktive p-Kanalgebiete 4. Weiterhin ist eine Schnittlinie BBn durch die aktiven n-Kanalgebiete 3, eine Schnittlinie BBp durch die aktiven p-Kanalgebiete 4 und eine Schnittlinie AA in Verlaufsrichtung der Wortleitungen 9, 10, 11 abwechselnd durch aktive n-Kanalgebiete und aktive p-Kanalgebiete, dargestellt.

Wird das Speicherzellenfeld 13 mit Stapelkondensatoren gebildet, so dient der n-Kanal-Kondensatoranschluß 5 und der p-Kanal-Kondensatoranschluß 6 dazu, einen Stapelkondensator anzuschließen. Für den Fall, daß das Speicherzellenfeld 13 mit Grabenkondensatoren 20 gebildet wird, so können die Grabenkondensatoren 20 unterhalb des n-Kanal-Kondensatoranschlusses 5 und unterhalb des p-Kanal-Kondensatoranschlusses 6 angeordnet werden. Das Speicherzellenfeld 13 aus Figur 1 ermöglicht eine Zellengröße der Speicherzellen von 6F². Ein Leseverstärker wird beispielsweise mit der ersten Bitleitung 22 und der zweiten Bitleitung 23 verbunden. Wird an die erste Wortleitung 9 eine erste Wortleitungsspannung 29 angelegt, so ist vorgesehen, daß der erste Auswahltransistor 16 und der zweite Auswahltransistor 17 beide sperren, so daß die erste Speicherzelle 14 und die zweite Speicherzelle 15 die in ihnen gespeicherte Information beibehalten. Wird nun eine zweite Wortleitungsspannung 30 an die erste Wortleitung 9 angelegt, so ist vorgesehen, daß sich der erste Auswahltransistor 16 öffnet und die in der ersten Speicherzelle 14 gespeicherte Ladung auf die erste Bitleitung 22 fließt. Der Leseverstärker vergleicht nun die Spannung an der ersten Bitleitung 22 und der zweiten Bitleitung 23, wobei für diesen Lesevorgang die zweite Bitleitung 23 als Referenzbitleitung dient.

Wird allerdings eine dritte Wortleitungsspannung 31 an die erste Wortleitung 9 angelegt, so ist vorgesehen daß sich der zweite Auswahltransistor 17 öffnet und die in dem zweiten Speicherkondensator 19 gespeicherte Ladung auf die zweite Bitleitung 23 fließt, wobei in diesem Fall der Leseverstärker die erste Bitleitung 22 als Referenzbitleitung nutzt, um das Ladungssignal auf der zweiten Bitleitung 23 zu bewerten.

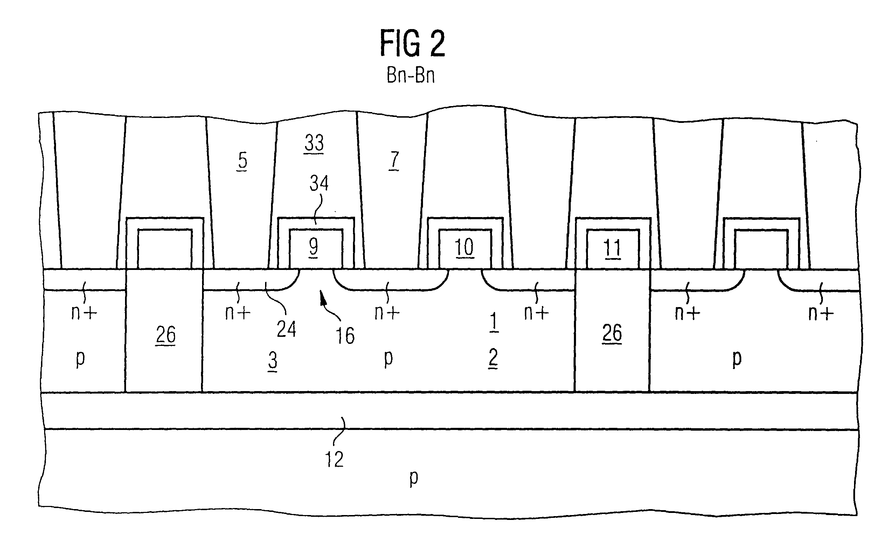

In den Figuren 2 bis 6 ist ausgehend von Figur 1 eine Variante mit Stapelkondensatoren 21 dargestellt. In Figur 2 ist ein Schnittbild entlang der Schnittlinie BBn aus Figur 1 dargestellt. In dem Substrat 1, bei dem es sich um ein SOI-Substrat 2 handelt, das eine Isolationsschicht 12 aufweist, ist ein erster Auswahltransistor 16 angeordnet. Der erste Auswahltransistor 16 weist ein erstes Source-Dotiergebiet 24 und eine erste Wortleitung 9 auf. Die erste Wortleitung 9 ist mit einer isolierenden Wortleitungshülle 34 umgeben. Weiterhin ist der erste Auswahltransistor 16 mit einem n-Kanal-Kondensatoranschluß 5 und einem ersten Bitleitungsanschluß 7 verbunden. Neben der ersten Wortleitung 9 ist eine zweite Wortleitung 10 und eine dritte Wortleitung 11 angeordnet. Die erste Wortleitung 9 und die zweite Wortleitung 10 verlaufen oberhalb eines aktiven n-Kanalgebiets 3, die dritte Wortleitung 11 verläuft oberhalb einer Grabenisolation 26. Das aktive n-Kanalgebiet 3 ist in diesem Ausführungsbeispiel von der Grabenisolation 26 eingeschlossen. In dieser Ausführungsform ist vorgesehen, daß die Grabenisolation 26 aus Siliziumoxid, das aktive n-Kanalgebiet 3 aus p-dotiertem Silizium, das erste Source-Dotiergebiet 24 aus hoch n-dotiertem Silizium und eine Isolationsschicht 33 aus BPSG (Bor Phosphor Silicate Glass) besteht.

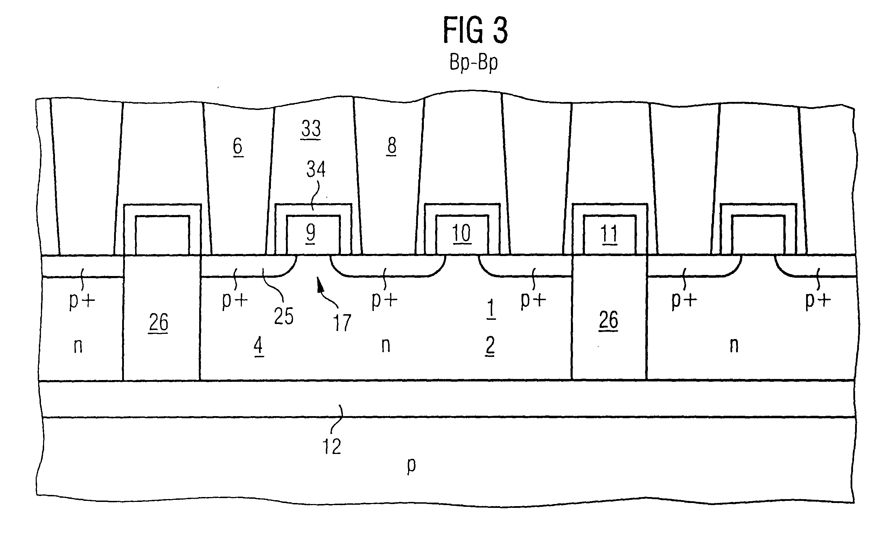

In Figur 3 ist ein Schnittbild entlang der Schnittlinie BBp aus Figur 1 dargestellt. Die Struktur der in Figur 3 dargestellten Anordnung ist äquivalent zu der in Figur 2 dargestellten Struktur, allerdings sind einige Dotierungen vertauscht, da hier ein aktives p-Kanalgebiet 4 für die p-Kanal-Transistoren verwendet wird. Bei dem Substrat 1 handelt es sich wieder um ein SOI-Substrat, wobei ein zweiter Auswahltransistor 17 in einem aktiven p-Kanalgebiet 4 gebildet ist. Der zweite Auswahltransistor 17 ist ebenfalls an die erste Wortleitung 9 angeschlossen, und weist darüber hinaus ein zweites, hoch n-dotiertes Source-Dotiergebiet 25 auf. Das zweite Source-Dotiergebiet 25 ist an einen p-Kanal-Kondensatoranschluß 6 angeschlossen. Darüber hinaus ist der zweite Auswahltransistor 17 über einen zweiten Bitleitungsanschluß 8 an die zweite Bitleitung 23 angeschlossen. Das SOI-Substrat 2 weist eine Isolationsschicht 12 auf. Das aktive p-Kanalgebiet 4 wird mittels der Grabenisolation 26 isoliert. Oberhalb des aktiven p-Kanalgebiets 4 verlaufen in diesem Ausführungsbeispiel die erste Wortleitung 9 und die zweite Wortleitung 10. Die dritte Wortleitung 11 verläuft oberhalb der Grabenisolation 26.

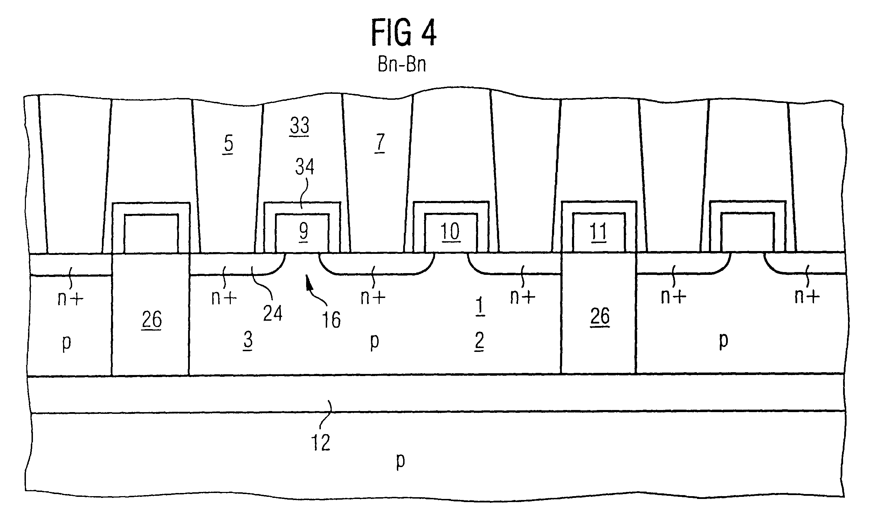

In Figur 4 ist ein weiteres Schnittbild entlang der Schnittlinie BBn aus Figur 1 dargestellt. Figur 4 unterscheidet sich von Figur 2 dahingehend, daß die Grabenisolation 26 nicht bis auf die isolierende Schicht 12 hinab reicht, da eine leitende Schicht 27 zwischen der Grabenisolation 26 und der Isolationsschicht 12 angeordnet ist. Die leitende Schicht 27 hat die Aufgabe, die für SOI-Transistoren typischen Effekte wie Substrataufladung zu verhindern. Um dies zu verhindern wird das aktive n-Kanalgebiet 3 über die leitende Schicht 27 elektrisch kontaktiert, so daß Ladungsträger, die in dem Substrat akkumuliert werden würden, durch die leitende Schicht 27 abfließen können.

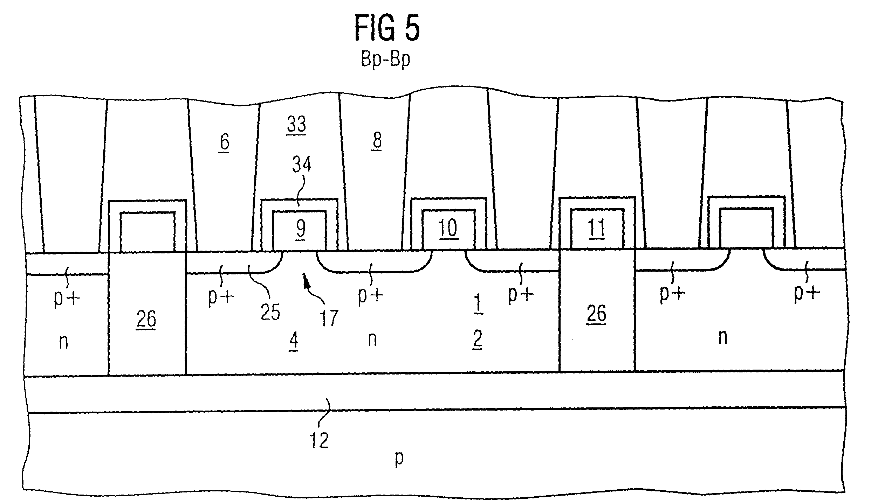

In Figur 5 ist ein weiteres Schnittbild entlang der Schnittlinie BBp aus Figur 1 dargestellt. Der Unterschied zu Figur 3 besteht darin, daß ebenfalls für die in dem aktiven p-Kanalgebiet 4 gebildeten p-Kanal-Transistoren SOI-Effekte vermieden werden. Dies geschieht auch hier dadurch, daß der Isolationsgraben 26 nicht bis auf die Isolationsschicht 12 hinab reicht, sondern eine leitende Schicht 27 zwischen dem Isolationsgraben 26 und der leitenden Schicht 12 angeordnet ist.

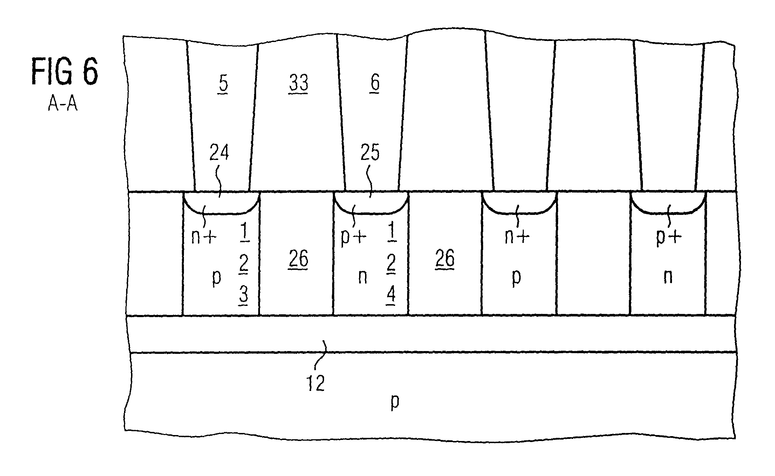

In Figur 6 ist ein Schnittbild entlang der Schnittlinie AA aus Figur 1 dargestellt. In dem Substrat 1, daß als SOI-Substrat 2 ausgebildet ist, ist die Isolationsschicht 12 angeordnet. Oberhalb der Isolationsschicht 12 sind abwechselnd aktive n-Kanalgebiete 3 und aktive p-Kanalgebiete 4 angeordnet, die durch eine Grabenisolation 26 voneinander isoliert werden. In dem aktiven n-Kanalgebiet 3 ist zum Beispiel das erste Source-Dotiergebiet 24 angeordnet, das über den n-Kanal-Kondensatoranschluß 5 mit dem ersten Kondensator 18, der als Stapelkondensator ausgebildet ist, angeschlossen ist. Neben dem aktiven n-Kanalgebiet 3 ist zunächst die Grabenisolation 26 angeordnet, neben der das aktive p-Kanalgebiet 4 angeordnet ist. In dem aktiven p-Kanalgebiet 4 ist das zweite Source-Dotiergebiet 25 im oberen Bereich angeordnet, das über den p-Kanal-Kondensatoranschluß 6 mit dem zweiten Speicherkondensator 19, der ebenfalls als Stapelkondensator ausgebildet ist, verbunden ist.

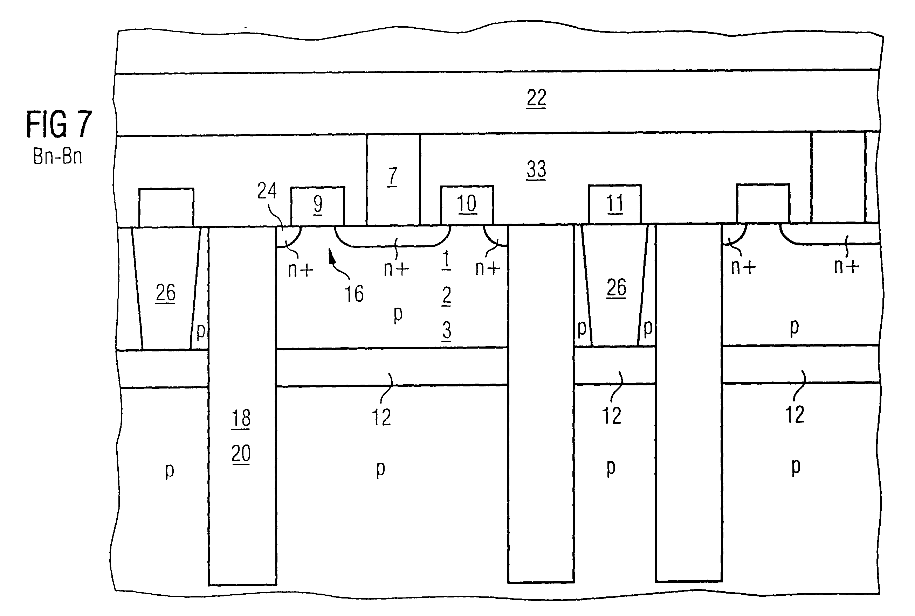

In den Figuren 7 bis 11 ist eine Variante mit Grabenkondensatoren zu dem in Figur 1 dargestellten Speicherzellenfeld 13 beschrieben. In Figur 7 ist ebenfalls das Substrat 1, das als SOI-Substrat 2 gebildet ist, mit der Isolationsschicht 12 versehen. Die Grabenkondensatoren 20 ragen durch die Isolationsschicht 12 hindurch. Beispielsweise ist in dem aktiven n-Kanalgebiet 3 ein erster Auswahltransistor 16 angeordnet, der ein erstes Source-Dotiergebiet 24 aufweist. Das erste Source-Dotiergebiet 24 ist beispielsweise an den ersten Speicherkondensator 18, der als Grabenkondensator 20 ausgebildet ist, angeschlossen. Weiterhin ist der erste Auswahltransistor 16 über den ersten Bitleitungsanschluß 7 an die erste Bitleitung 22 angeschlossen. Neben der ersten Wortleitung 9 die den ersten Auswahltransistor 16 steuert, verlaufen eine zweite Wortleitung 10 und eine dritte Wortleitung 11. Die zweite Wortleitung 10 verläuft ebenfalls oberhalb des aktiven n-Kanalgebiets 3, die dritte Wortleitung 11 verläuft oberhalb einer Grabenisolation 26. Zur Planarisierung der Oberfläche dient eine Isolationsschicht 33, die beispielsweise aus einem BPSG gebildet ist.

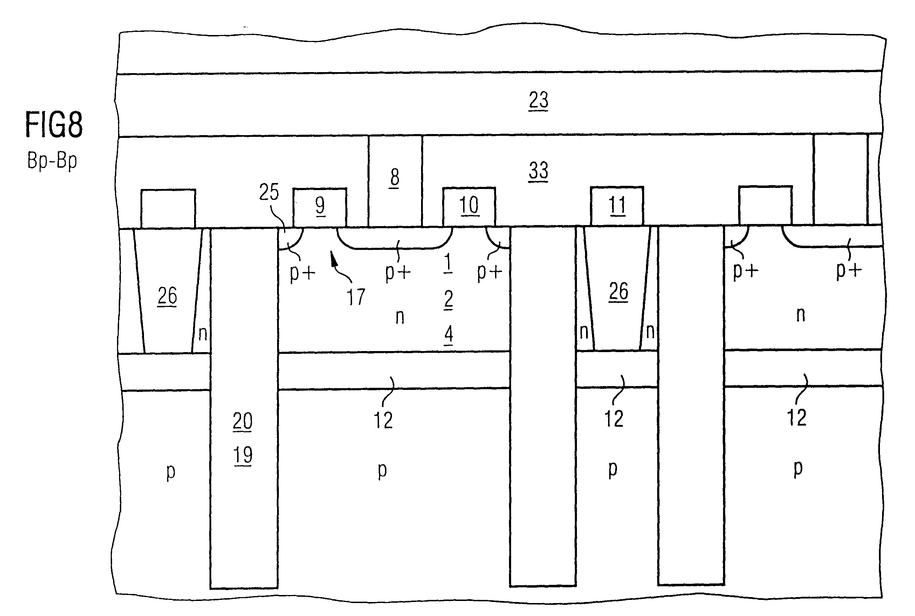

In Figur 8 ist ein Schnittbild entlang der Schnittlinie BBp aus Figur 1 dargestellt. Die Anordnung ist in dem Substrat 1 gebildet, bei dem es sich um ein SOI-Substrat 2 handelt. Die Grabenkondensatoren erstrecken sich auch hier durch die Isolationsschicht 12. Oberhalb der Isolationsschicht 12 ist ein aktives p-Kanalgebiet 4, in dem ein zweiter Auswahltransistor 17 gebildet ist. Der zweite Auswahltransistor 17 weist ein zweites Source-Dotiergebiet 25 auf, das an einen zweiten Speicherkondensator 19 angeschlossen ist, der als Grabenkondensator 20 ausgebildet ist. Der zweite Auswahltransistor 17 wird mittels der ersten Wortleitung 9 gesteuert. Weiterhin ist der zweite Auswahltransistor 17 über den zweiten Bitleitungsanschluß 8 mit der zweiten Bitleitung 23 verbunden. Zwischen der Bitleitung 23 und den Auswahltransistoren 16, 17 ist eine Isolationsschicht 33 aus BPSG angeordnet. Benachbarte Speicherzellen sind in diesem Ausführungsbeispiel mittels der Grabenisolation 26 voneinander isoliert.

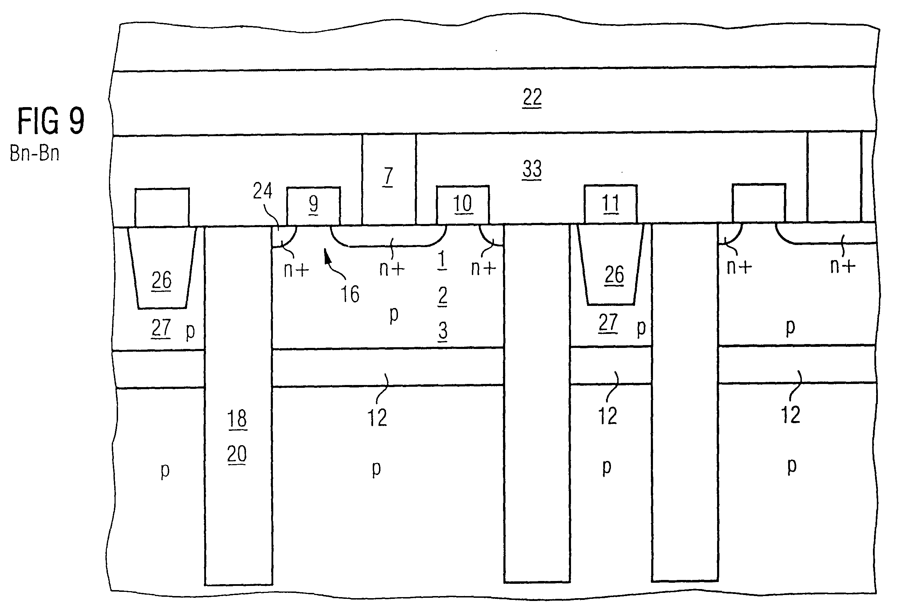

In Figur 9 ist ein weiteres Schnittbild entlang der Schnittlinie BBn aus Figur 1 dargestellt. Figur 9 unterscheidet sich von Figur 7 dahingehend, daß die Grabenisolation 26 nicht bis zu der Isolationsschicht 12 heranreicht, sondern eine leitende Schicht 27 zwischen der Grabenisolation 26 und der Isolationsschicht 12 angeordnet ist. Dies hat den Vorteil, daß SOI-Effekte der Auswahltransistoren vermieden werden, da die Ladung abtransportiert werden kann, die sich üblicherweise im Substrat ansammeln würde.

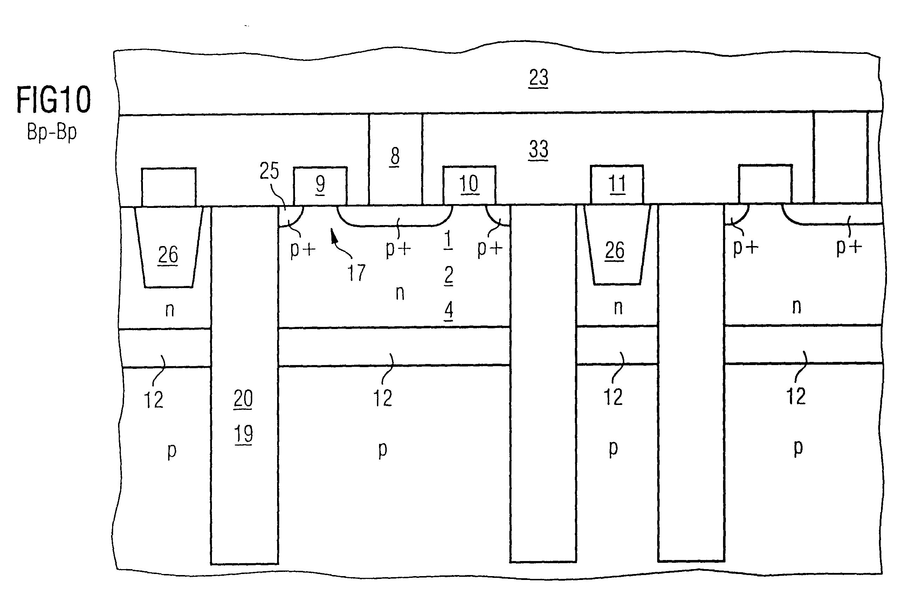

In Figur 10 ist ein weiteres Schnittbild entlang der Schnittlinie BBp aus Figur 1 dargestellt. Figur 10 unterscheidet sich von Figur 8 dahingehend, daß die Grabenisolation 26 nicht bis zu der Isolationsschicht 12 heranreicht, sondern eine leitende Schicht 27 zwischen der Grabenisolation 26 und der Isolationsschicht 12 angeordnet ist. Dies hat den Vorteil, daß SOI-Effekte der Auswahltransistoren vermieden werden, da die Ladung abtransportiert werden kann, die sich üblicherweise im Substrat ansammeln würde.

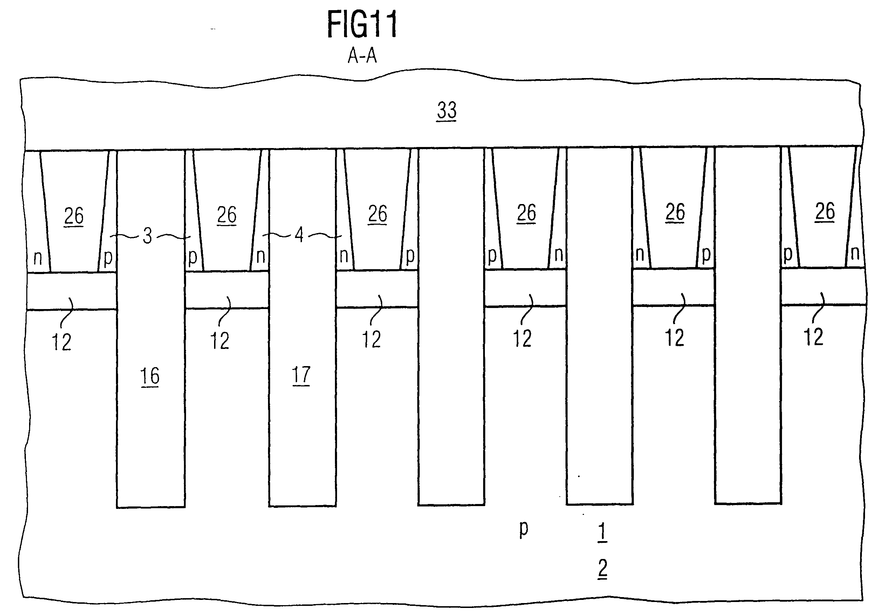

In Figur 11 ist ein Schnittbild entlang der Schnittlinie AA aus Figur 1 dargestellt. Bei dem Substrat 1 handelt es sich wiederum um ein SOI-Substrat, daß eine Isolationsschicht 12 aufweist. Der erste Speicherkondensator 18 und der zweite Speicherkondensator 19 sind als Grabenkondensatoren 20 ausgebildet und erstrecken sich durch die Isolationsschicht 12. Oberhalb der Isolationsschicht 12 sind die einzelnen Grabenkondensatoren und die sie umgebenden aktiven Kanalgebiete 3, 4 mittels einer Grabenisolation 26 voneinander isoliert. Dabei ist um den ersten Speicherkondensator 18 das aktive n-Kanalgebiet 3 und um den zweiten Speicherkondensator 19 das aktive p-Kanalgebiet 4 ausgebildet. Oberhalb der Grabenkondensatoren 20 und des Isolationsgrabens 26 ist ein Isolationsschicht 33 aus BPSG angeordnet.

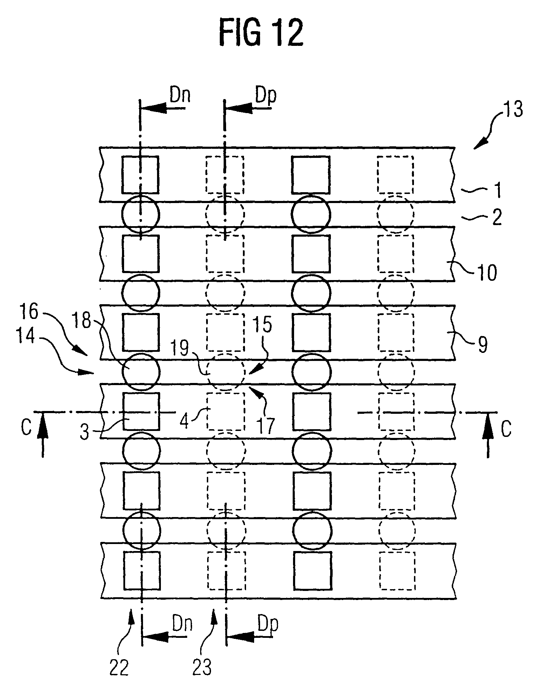

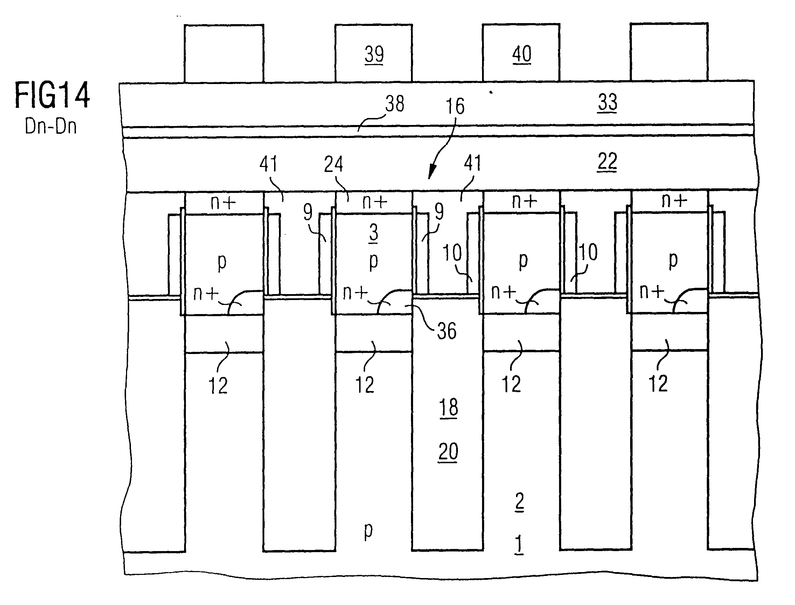

In Figur 12 ist ein weiteres Speicherzellenfeld 13 dargestellt. Dieses Speicherzellenfeld ermöglicht eine Speicherzellengröße von 4F². bei dem Substrat 1 handelt es sich beispielsweise um ein SOI-Substrat 2. In dem SOI-Substrat 2 ist ein aktives n-Kanalgebiet 3 und ein aktives p-Kanalgebiet 4 angeordnet. Das aktive n-Kanalgebiet 3 und das aktive p-Kanalgebiet 4 sind von einer Spacer-Wortleitung (seitlicher Randsteg) umgeben. In Zusammenhang mit dem aktiven n-Kanalgebiet 3 ist eine erste Speicherzelle 14 mit einem ersten Auswahltransistor 16 und einem ersten Speicherkondensator 18 gebildet. Im Zusammenhang mit dem aktiven p-Kanalgebiet 4 ist eine zweite Speicherzelle 15 bestehend aus einem zweiten Auswahltransistor 17 und einem zweiten Speicherkondensator 19 gebildet. Die erste Speicherzelle 14 ist an eine erste Bitleitung 22, die zweite Speicherzelle 15 an eine zweite Bitleitung 23 angeschlossen. Weiterhin sind an die erste Bitleitung 22 benachbarte Speicherzellen mit aktivem n-Kanalgebiet angeschlossen. An die zweite Bitleitung 23 sind weitere Speicherzellen mit aktivem p-Kanalgebiet angeschlossen. Neben der ersten Wortleitung 9 ist eine zweite Wortleitung 10 angeordnet. Schnittbilder sind entlang der Schnittlinie DDn, DDp und CC in den Figuren 14 bis 16 dargestellt.

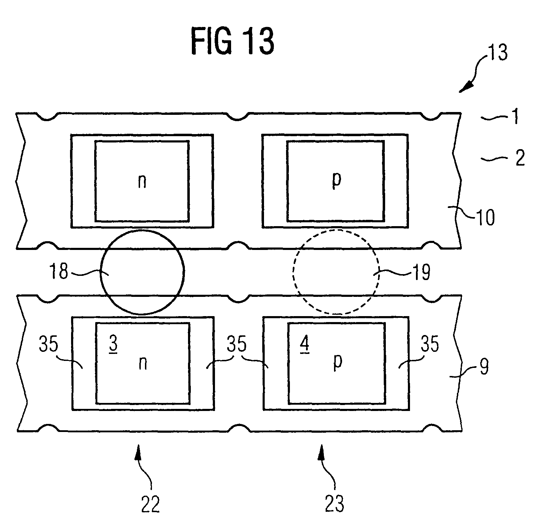

In Figur 13 ist eine herausvergrößerte Draufsicht des in Figur 12 dargestellten Speicherzellenfeldes 13 abgebildet. In dem Substrat 1, das als SOI-Substrat 2 gebildet ist, ist ein aktives n-Kanalgebiet 3 und ein aktives p-Kanalgebiet 4 angeordnet. In diesem Ausführungsbeispiel sind die aktiven n-Kanal- und p-Kanalgebiete zu beiden Seiten mit der Periode des kleinsten Strukturmasses F angeordnet. Die erste Wortleitung 9 ist als Spacer-Wortleitung um das aktive n-Kanalgebiet 3 und das aktive p-Kanalgebiet 4 gebildet. Die zweite Wortleitung 10 ist benachbart zu der ersten Wortleitung 9 angeordnet. Quer zum Verlauf der ersten Wortleitung 9 sind seitliche Isolationsrandstege 35 an den aktiven Kanalgebieten 3, 4 gebildet.

In Figur 14 ist ein Schnittbild entlang der Schnittlinie DDn aus Figur 12 dargestellt. In dem Substrat 1 ist eine Isolationsschicht 12 angeordnet, da das Substrat als SOI-Substrat 2 ausgebildet ist. Oberhalb der Isolationsschicht 12 ist ein aktives n-Kanalgebiet 3, in dem der erste Auswahltransistor 16 als vertikaler Transistor gebildet ist. Dabei weist der erste Auswahltransistor 16 ein erstes Source-Dotiergebiet 24 und ein erstes Drain-Dotiergebiet 36 auf. Das erste Drain-Dotiergebiet 36 ist mit dem ersten Speicherkondensator 18 verbunden, der als Grabenkondensator 20 ausgebildet ist. Die erste Wortleitung 9 verläuft neben dem aktiven n-Kanalgebiet 3 und wird durch ein Gate-Oxid isoliert. Benachbart zu dem aktiven n-Kanalgebiet 3 ist ein weiteres aktives n-Kanalgebiet, das von der zweiten Wortleitung 10 umgeben ist. Das erste Source-Dotiergebiet 24 ist mit der ersten Bitleitung 22 verbunden. Benachbarte Wortleitungen sind mit der Isolation 41 voneinander isoliert. Die erste Bitleitung 22 ist mit einer Bitleitungsisolationshülle 38 isoliert. Oberhalb der Bitleitungsisolationshülle 38 ist eine Isolationsschicht 33 angeordnet. Oberhalb der Isolationsschicht 33 verlaufen eine erste Metallwortleitung 39 und eine zweite Metallwortleitung 40, die mit der ersten Wortleitung 9 und der zweiten Wortleitung 10 verbunden sind, um die als Spacer ausgebildeten Wortleitungen 9, 10 niederohmiger zu gestalten.

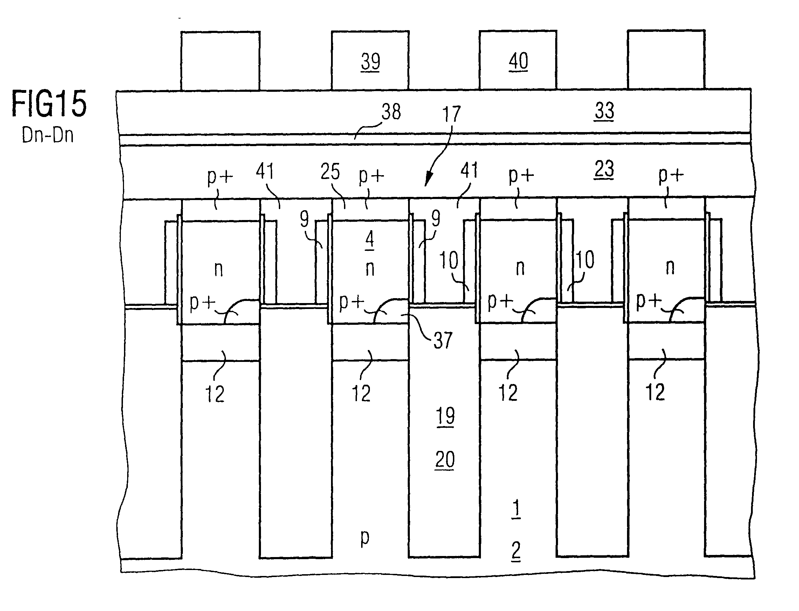

In Figur 15 ist ein Schnittbild entlang der Schnittlinie DDp aus Figur 12 dargestellt. Figur 15 entspricht der in Figur 14 dargestellten Struktur bis auf die Dotierung, die für die Ausbildung von p-Kanal-Transistoren invertiert wurde. In dem Substrat 1 ist die Isolationsschicht 12 angeordnet, so daß das Substrat 1 als SOI-Substrat 2 ausgebildet ist. Oberhalb der Isolationsschicht 12 ist das aktive p-Kanalgebiet 4 angeordnet, in dem der zweite Auswahltransistor 17 gebildet ist. Der zweite Auswahltransistor 17 weist ein zweites Source-Dotiergebiet 25 und ein zweites Drain-Dotiergebiet 37, das an den zweiten Speicherkondensator 19 angeschlossen ist, der ebenfalls als Grabenkondensator 20 ausgebildet ist. Das zweite Source-Dotiergebiet 25 ist an eine zweite Bitleitung 23 angeschlossen. Das aktive p-Kanalgebiet 4 wird von der ersten Wortleitung 9, die auch den zweiten Auswahltransistor 17 steuert, durch ein Gate-Oxid isoliert. Benachbart zu der ersten Wortleitung 9 verläuft die zweite Wortleitung 10, die hier ebenfalls ein aktives p-Kanalgebiet umgibt. Oberhalb der zweiten Bitleitung 23 ist eine Bitleitungsisolationshülle 38 angeordnet, auf der die Isolationsschicht 33 verläuft. Oberhalb der Isolationsschicht 33 sind die erste Metallwortleitung 39 und die zweite Metallwortleitung 40 angeordnet, die mit der ersten Wortleitung 9 und der zweiten Wortleitung 10 verbunden sind, um diese niederohmiger auszubilden.

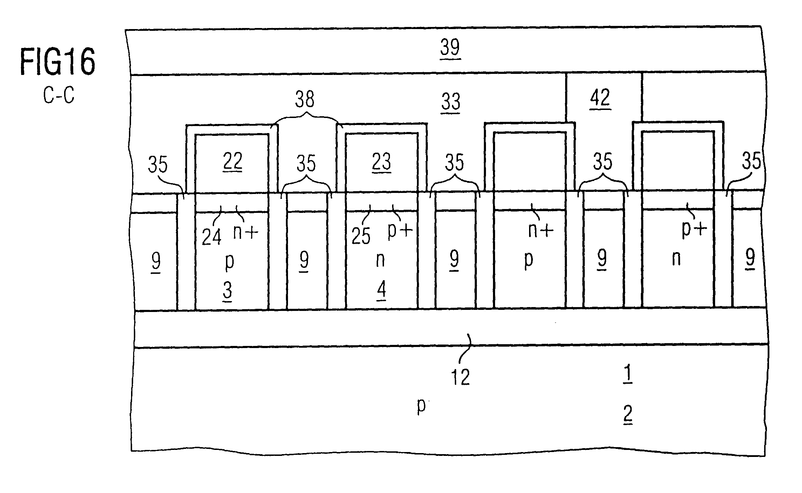

In Figur 16 ist ein Schnittbild entlang der Schnittlinie CC aus Figur 12 dargestellt. Das SOI-Substrat 2 weist eine Isolationsschicht 12 auf, auf der abwechselnd aktives n-Kanalgebiet 3 und aktives p-Kanalgebiet 4 angeordnet sind. Das aktive n-Kanalgebiet 3 und das aktive p-Kanalgebiet 4 sind von seitlichen Isolationsrandstegen 35 (spacer) isoliert. Weiterhin verläuft die erste Wortleitung 9 neben dem aktiven n-Kanalgebiet 3 und dem aktiven p-Kanalgebiet 4. Das erste Source-Dotiergebiet 24 ist an die erste Bitleitung 22 und das zweite Source-Dotiergebiet 25 ist an die zweite Bitleitung 23 angeschlossen. Die erste Bitleitung 22 und die zweite Bitleitung 23 sind von einer Bitleitungsisolationshülle 38 umgeben. Zur Planarisierung ist eine Isolationsschicht 33 aus BPSG oberhalb der Bitleitungen angeordnet. Durch die Isolationsschicht 33 hindurch ist ein metallischer Wortleitungskontakt 42 vorgesehen, mit dem die erste Metallwortleitung 39 die oberhalb der Isolationsschicht 33 verläuft, mit der ersten Wortleitung 9 verbunden wird.

Üblicherweise ist das Substrat aus Silizium gebildet. Auch das in diesem Fall verwendete SOI-Substrat besteht aus Silizium, weist allerdings eine vergrabene Isolationsschicht 12 in dem Substrat 1 auf. Bei dem aktiven n-Kanalgebiet handelt es sich beispielsweise um ein schwach p-dotiertes Silizium, das aktive p-Kanalgebiet ist ein schwach n-dotiertes Silizium.

### Bezugszeichenliste

- 1: Substrat
- 2: SOI-Substrat
- 3: Aktives n-Kanalgebiet
- 4: Aktives p-Kanalgebiet
- 5: n-Kanal-Kondensatoranschluß
- 6: p-Kanal-Kondensatoranschluß
- 7: Erster Bitleitungsanschluß
- 8: Zweiter Bitleitungsanschluß
- 9: Erste Wortleitung
- 10: Zweite Wortleitung
- 11: Dritte Wortleitung
- 12: Isolationsschicht
- 13: Speicherzellenfeld
- 14: Erste Speicherzelle
- 15: Zweite Speicherzelle
- 16: Erster Auswahltransistor
- 17: Zweiter Auswahltransistor
- 18: Erster Speicherkondensator
- 19: Zweiter Speicherkondensator
- 20: Grabenkondensator
- 21: Stapelkondensator
- 22: Erste Bitleitung
- 23: Zweite Bitleitung
- 24: erstes Source-Dotiergebiet
- 25: zweites Source-Dotiergebiet
- 26: Grabenisolation
- 27: leitende Schicht
- 28: Dotierstoff
- 29: erste Wortleitungsspannung
- 30: zweite Wortleitungsspannung
- 31: dritte Wortleitungsspannung
- 32: Gate-Material
- 33: Isolationsschicht
- 34: isolierende Wortleitungshülle
- 35: Isolationsrandsteg
- 36: erstes Drain-Dotiergebiet
- 37: zweites Drain-Dotiergebiet
- 38: isolierende Bitleitungshülle
- 39: erste Metallwortleitung
- 40: zweite Metallwortleitung
- 41: Isolation
- 42: Metallwortleitungskontakt

## Patentansprüche

1. Halbleiterspeicher mit einem Speicherzellenfeld (13), in dem
- eine erste Speicherzelle (14) mit einem ersten Auswahltransistor (16) und einem ersten Speicherkondensator (18) und
- eine zweite Speicherzelle (15) mit einem zweiten Auswahltransistor (17) und einem zweiten Speicherkondensator (19) angeordnet sind,
- wobei der erste Auswahltransistor (16) ein n-Kanal-Transistor und der zweite Auswahltransistor (17) ein p-Kanal-Transistor ist und
- wobei die Speicherzellen (14, 15) in einem SOI-Substrat (2), das eine Isolationsschicht (12) aufweist, gebildet sind.

2. Halbleiterspeicher nach Anspruch 1,
**dadurch gekennzeichnet, daß**
mindestens einer der Speicherkondensatoren (18, 19) ein Grabenkondensator (20) ist.

3. Halbleiterspeicher nach Anspruch 1,
**dadurch gekennzeichnet, daß**
mindestens einer der Speicherkondensatoren (18, 19) ein Stapelkondensator (21) ist.

4. Halbleiterspeicher nach einem der Ansprüche 1 bis 3,
**dadurch gekennzeichnet, daß**
eine Grabenisolation (26) und die Isolationsschicht (12) den ersten Auswahltransistor (16) von dem zweiten Auswahltransistor (17) isolieren.

5. Halbleiterspeicher nach einem der Ansprüche 1 bis 4,
**dadurch gekennzeichnet, daß**
der erste Auswahltransistor (16) oder der zweite Auswahltransistor (17) als vertikaler Transistor gebildet sind.

6. Halbleiterspeicher nach einem der Ansprüche 1 bis 5,
**dadurch gekennzeichnet, daß**
der erste Auswahltransistor (16) ein Gate aus einem Mid-Gap-Material aufweist, welches so gewählt ist, **daß** die Einsatzspannung des ersten Auswahltransistors (16) die negative Einsatzspannung des zweiten Auswahltransistors (17) ist.

7. Halbleiterspeicher nach einem der Ansprüche 1 bis 6,
**dadurch gekennzeichnet, daß**
als ein Gate-Material für den ersten Auswahltransistor (16) und/oder für den zweiten Auswahltransistor (17) ein mit Dotierstoff dotiertes Polysilizium verwendet wird.

8. Halbleiterspeicher nach einem der Ansprüche 6 oder 7,
**dadurch gekennzeichnet, daß**
als Dotierstoff Germanium verwendet wird.

9. Halbleiterspeicher nach einem der Ansprüche 1 bis 8,
**dadurch gekennzeichnet, daß**
ein Gate-Material für den ersten Auswahltransistor (16) und/oder für den zweiten Auswahltransistor (17) Titannitrid, Wolfram oder Tantal enthält.

10. Halbleiterspeicher nach einem der Ansprüche 1 bis 9,
**dadurch gekennzeichnet, daß**
zur Verbindung des ersten Speicherkondensators (18) mit einem Source-Dotiergebiet (24) des ersten Auswahltransistors (16) und/oder zur Verbindung des zweiten Speicherkondensators (19) mit einem zweiten Source-Dotiergebiet (25) des zweiten Auswahltransistors (17) ein Silizid verwendet wird.

11. Halbleiterspeicher nach einem der Ansprüche 5 bis 10,
**dadurch gekennzeichnet, daß**
zwischen der Grabenisolation (26) und einer Isolationsschicht (12) des SOI-Substrats (2) eine leitfähige Schicht (27) angeordnet ist.
